# EUROPÄISCHE PATENTSCHRIFT

(11) **EP 0 272 433 B1**
(45) Veröffentlichungstag und Bekanntmachung des Hinweises auf die Patenterteilung: **31.03.1993**
(21) Anmeldenummer: 87116666.6
(22) Anmeldetag: 11.11.1987
(51) Int. Cl.: H01L 21/90, H01L 27/06

(54) **Integrierte Halbleiterschaltung mit als Dünnschichtstege auf den die aktiven Transistorbereiche trennenden Feldoxidbereichen angeordneten Lastwiderstände und Verfahren zu ihrer Herstellung**
Integrated semiconductor circuit having load resistors arranged as thin-film bars in the field oxide regions separating the active transistor regions, and process for their manufacture
Circuit intégré semi-conducteur avec des résistances de charge arrangées sur les régions des oxydes de champ séparant les roues actives des transistors et son mode de fabrication

(30) Priorität: 18.11.1986 DE 3639357
(43) Veröffentlichungstag der Anmeldung: 29.06.1988
(73) Patentinhaber: SIEMENS AKTIENGESELLSCHAFT, 80333 München (DE)
(72) Erfinder: Winnerl, Josef, Dr. rer. nat., D-8300 Landshut (DE); Neppl, Franz, Dr. rer. nat., D-8000 München 90 (DE)

(56) Entgegenhaltungen:
- EP-A- 0 124 960
- US-A- 4 528 582
- IEEE TRANSACTIONS ON ELECTRON DEVICES, Band ED-26, Nr. 4, April 1979, Seiten 385-389, New York, US; K. OKADA et al.: "A new polysilicon process for a bipolar device - PSA technology"
- IBM TECHNICAL DISCLOSURE BULLETIN, Band 21, Nr. 3, August 1978, Seiten 1250-1251, New York, US; V.L. RIDEOUT: "Fabricating low resistance interconnection lines and fet gates in a single step"
- IEEE JOURNAL OF SOLID-STATE CIRCUITS, Band SC-15, Nr. 4, August 1980, Seiten 474-482, IEEE, S.P. MURARKA et al.: "Refractory silicides of titanium and tantalum for low-resistivity gates and interconnects"

## Beschreibung

Die Erfindung betrifft eine integrierte MOS-Transistoren oder MOS-Transistoren und Bipolar-Transistoren und als Dünnschichtstege auf den die aktiven Transistorbereiche trennenden Feldoxidbereichen angeordnete Lastwiderstände enthaltende Schaltung mit Gate-Elektroden oder mit Gateelektroden und Emitter- bzw. Basisanschlüssen aus einer Doppelschicht aus polykristallinem Silizium und einem hochschmelzenden Metallsilizid und Verfahren zu ihrer Herstellung.

Moderne Verfahren zur Herstellung von Bipolartransistoren und MOS-Transistoren hoher Schaltgeschwindigkeit verwenden polykristalline Siliziumschichten als Diffusionsquellen, Anschluß- und Gatematerialien. Als großer weiterer Vorteil können in den Schaltungen benötigte Widerstände äußerst platzsparend und kapazitätsarm als Dünnschicht-Stege auf den die aktiven Transistorbereiche der Schaltung trennenden Feldoxidbereichen ausgeführt werden. Eine solche Transistorschaltung ist beispielsweise in N. C. C. Lu et al.: IEEE Trans. El. Dev., ED-29, Seiten 682 bis 690, April 1982, beschrieben.

In einer gemischten Bipolar/CMOS-Technologie (CMOS = Complementäre MOS-Transistorschaltung) bietet sich die aus polykristallinem Silizium bestehende Gate-Elektrode zur Realisierung von Lastwiderständen an. Wegen der höheren Austrittsarbeit der Gates wird als Gatematerial hochschmelzende Metallsilizide bzw. Doppelschichten aus polykristallinem Silizium und Metallsiliziden verwendet. Diese sind aber wegen des geringen Schichtwiderstandes (2 bis 5 Ohm pro square) zur Realisierung von Lastwiderständen, deren Schichtwiderstand im Kiloohmbereich und höher liegt, nicht geeignet.

Aus K. Okada et al, IEEE Transactions on Electron. Devices, Band ED-26, 1979, S. 385 - 389 ist ein Verfahren zur Herstellung eines Bipolartransistors nach der sogenannten PSA-Methode bekannt. Aus einer polykristallinen Siliziumschicht werden dabei Elektroden für einen Emitter und einen Kollektor gebildet. Aus derselben polykristallinen Siliziumschicht wird ein Widerstand gebildet. Die polykristalline Siliziumschicht wird unter Verwendung einer Si₃N₄-Maske durch selektive thermische Oxidation strukturiert. Dazu werden diejenigen Bereiche der polykristallinen Schicht, in denen der Emitteranschluß, der Kollektoranschluß und der Widerstand entstehen sollen, mit Si₃N₄ bedeckt. Die freiliegenden Bereiche der polykristallinen Siliziumschicht werden durch thermische Oxidation vollständig durchoxidiert. Dabei erfolgt die Oxidation auch an den Rändern der mit Si₃N₄ bedeckten polykristallinen Siliziumschicht, so daß die nichtoxidierten Siliziumbereiche kleiner sind als die von Si₃N₄ bedeckte Fläche. Zwischen den Anschlüssen aus polykristallinem Silizium bzw. dem Widerstand aus polykristallinem Silizium verbleibt die Siliziumoxidstruktur zur Isolation.

Aufgabe der Erfindung ist es, eine integrierte Halbleiterschaltung der eingangs genannten Art anzugeben, bei der die Gateebene einer CMOS- bzw. Bipolar/CMOS-Schaltung für Lastwiderstände genutzt werden kann, die Gateebene aber niederohmig ist.

Diese Aufgabe wird dadurch gelöst, daß die Lastwiderstände in der gleichen Ebene wie die Gate-Elektroden angeordnet sind und aus dotierten, polykristallinen Siliziumschichtstrukturen und ihre Anschlüsse aus einem hochschmelzenden Metallsilizid bestehen. Da für die Lastwiderstände nur das polykristalline Silizium der Gateebene ohne das darüberliegende Metallsilizid verwendet wird, die Gates aber aus einer Doppelschicht von polykristallinem Silizium und Metallsilizid bestehen, wobei ein niedriger Schichtwiderstand der Gates und der Verdrahtung in der Gateebene (2 bis 5 Ohm pro square) erreicht wird, kann der Schichtwiderstand der Lastwiderstände unabhängig von dem der Gates eingestellt werden. Dies ist ein wesentlicher Punkt der Erfindung.

Der Dotierung der polykristallinen Siliziumschicht kann dabei gerade so niedrig gewählt werden, daß die Austrittsarbeit der Gates noch ausreichend ist (Schichtwiderstand kleiner 100 Ohm pro square). Es können aber auch höhere Schichtwiderstände (größer 100 Ohm pro square) erreicht werden, indem die Austrittsarbeit der Gates durch eine zusätzliche Ionenimplantation unabhängig von der Dotierung der Lastwiderstände eingestellt wird. Derartige aus polykristallinem Silizium bestehende Lastwiderstände sind zum Beispiel in Bipolar/CMOS-Technologie mit implantierten Emittern, wie beispielsweise in der nachveröffentlichten europäischen Patentanmeldung EP-A-0 204 979 (Stand der Technik gemäß Art. 54 (3) EPÜ) oder mit Polysilizium-Emittern, wie beispielsweise in der nachveröffentlichten europäischen Patentanmeldung EP-A-0 219 641 (Stand der Technik gemäß Art. 54 (3) EPÜ) beschrieben oder in einer reinen CMOS-Technologie (Verfahren zur Herstellung von komplementären n-Kanal- und p-Kanal-MOS Transistoren) gut realisierbar.

Verfahren zu dieser Realisierung sind ein Teil der vorliegenden Erfindung und als Weiterbildungen in Unteransprüchen enthalten.

Im folgenden wird anhand der Figuren 1 bis 5 und drei Ausführungsbeispiele die Erfindung, inbesondere Verfahren zur Herstellung von Polysiliziumlastwiderständen in integrierten MOS-Tran-sistoren enthaltenden Schaltungen noch näher beschrieben. Dabei zeigen
- die Figuren 1 bis 3: im Schnittbild die erfindungswesentlichen Verfahrensschritte zur Herstellung eines Polysiliziumlastwiderstandes neben einer MOS-Tansistorstruktur und
- die Figuren 4 und 5: die Herstellung einer Anordnung unter Verwendung von Flankenisolationsschichten (sogenannte side wall spacer). Diese Technik wird verwendet, um die Isolation von Source/Drain-Gebieten zum Gate zu gewährleisten.

In allen Figuren gelten für gleiche Teile die gleichen Bezugszeichen.

### Ausführungsbeispiel 1:

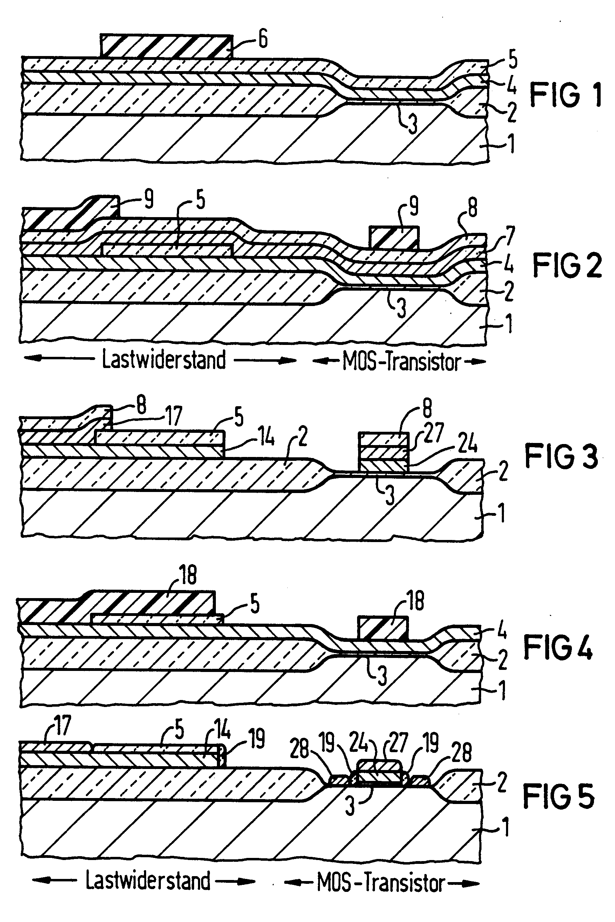

Figur 1: Es werden die erfindungswesentlichen Verfahrensschritte bei der Herstellung von Polysiliziumlastwiderständen in der Gate-Ebene einer Bipolar/CMOS-Schaltung beschrieben. Dabei wird die Prozeßfolge zur Erzeugung der in Figur 1 abgebildeten Struktur, was die Herstellung des vergrabenen Kollektorbereiches, der p- bzw. n-Wanne im Substrat, der Feldimplantation, der Erzeugung des Feldoxides, der Basisimplantation, der Erzeugung des Gateoxids und der Kanalimplantation betrifft, zum Beispiel wie bei dem in der nach veröffentlichten europäischen Patentanmeldung EP-A-0 204 979 beschriebenen Verfahrensablauf durchgeführt. Der besseren Übersicht wegen sind in den Figuren der vergrabene Kollektorbereich, die implantierten Wannen, die Feldimplantation, die Basisimplantation und die Kanalimplantation nicht eingezeichnet. Mit dem Bezugszeichen 1 ist das Siliziumsubstrat oder der Wannenbereich (n- oder p-Wanne), mit 2 das die aktiven Transistorbereiche trennende Feldoxid und mit 3 das Gateoxid bezeichnet.

Der erste erfindungswesentliche Schritt ist die Abscheidung einer dotierten oder undotierten polykristallinen Siliziumschicht 4. Bei einer undotierten polykristallinen Siliziumschicht 4 erfolgt die Dotierung nach der Abscheidung aus der Gasphase entweder durch Ionenimplantation oder durch Diffusion. In jedem Fall wird damit der Schichtwiderstand des Polysiliziumlastwiderstandes (14 in Figur 3) eingestellt. Auf die polykristalline Siliziumschicht 4 wird ganzflächig dann eine Siliziumoxidschicht 5 aufgebracht. Diese SiO-₂Schicht 5 wird entsprechend der Definition des Lastwiderstandsbereiches (14 in Figur 3) mit einer Fotolackmaske 6 bedeckt.

Figur 2: Mittels der Fotolackmaske 6 wird die SiO₂-Schicht 5 über dem Lastwiderstandsbereich 14 strukturiert. Auf diese Anordnung wird dann ganzflächig eine zum Beispiel aus Tantaldisilizid bestehende Schicht 7 aufgebracht, und darauf eine weitere SiO₂-Schicht 8, die bei der später erfolgenden Source/Drain-Ionenimplantation des MOS-Transistors eine unerwünschte Dotierung der Gates (24, 27 in Figur 3) verhindert. Die Anordnung wird dann zur Definition der Gates (24, 27) und der Anschlüsse (17) der Lastwiderstände (14) mit einer Fotolackmaske (9) versehen.

Figur 3 zeigt die nach der Strukturierung der Oxidschicht 8, der Tantaldisilizidschicht 7 und der polykristallinen Siliziumschicht 4 im Gatebereich erhaltene Anordnung, wobei die zuerst aufgebrachte SiO-₂Schicht 5 als Schichtstruktur über dem Lastwiderstand 14 als Ätzstop bei der Polysiliziumätzung wirkt. Die weitere Prozeßfolge (wie Source/Drain-Ionenimplantationen, Emitterimplantation, Zwischenisolation, Erzeugung der Basisbereiche, Kontaktierung und Passivierung) erfolgt in bekannter Weise.

### Ausführungsbeispiel 2 (keine zusätzlichen Figuren):

In der eben anhand der Figuren 1 bis 3 beschriebenen Version ist der Schichtwiderstand der Polysiliziumwiderstände (14) dadurch begrenzt, daß die Dotierung der polykristallinen Siliziumschicht (4, 14, 24) für die nötige Austrittsarbeit der Gates ausreichen muß. Soll aber die Austrittsarbeit der Gates (24, 27) unabhängig vom Schichtwiderstand der Widerstände (14) eingestellt werden (wenn zum Beispiel hochohmige Widerstände erforderlich sind), so wird eine zusätzliche Ionenimplantation der Tantalsilizidschicht 7 durchgeführt oder die Tantaldisilizidschicht 7 mit zum Beispiel einer n⁺-Dotierung abgeschieden. Zur Einstellung der Gate-Austrittsarbeit wird dann der im Silizid vorhandene Dotiertoff in das polykristalline Silizium (24) ausdiffundiert, wobei die Oxidmaske (5) über dem Lastwiderstandsbereich (14) als Diffusionsbarriere wirkt und damit eine Erhöhung der Dotierung im Bereich der Polysiliziumlastwiderstände (14) verhindert. Weitere Prozeßschritte erfolgen wie bei den Figuren 1 bis 3 beschrieben.

### Ausführungsbeispiel 3:

Abweichend von den in den Figuren 1 bis 3 beschriebenen Ausführungsbeispielen wird in der folgenden Prozeßfolge eine selektive Silizierung der Source/Drain-Gebiete des MOS-Transistors beschrieben.

Figur 4: Ausgehend von dem in Figur 1 im Ausführungsbeispiel 1 durchgeführten Prozeßschritten wird nach der Abscheidung der polykristallinen Siliziumschicht 4 und der Oxidschicht 5 auf dem mit dem Feldoxid 2 und dem Gateoxid 3 versehenen Siliziumsubstrat 1 (oder n- oder p-Wannenbereich) und nach dem Strukturieren der Oxidschicht 5 zur Definition des Polysiliziumlastwiderstandesbereiches 14 eine Fotolackmaske 18 zur Definition der Gates (24, 27) aufgebracht. Es erfolgt die Strukturierung der polykristallinen Siliziumschicht 4 im Gatebereich mit der Fotolackmaske 18 als Ätzmaske.

Figur 5: An den freiliegenden Seitenwänden der polykristallinen Siliziumschichtstrukturen 14 und 24 werden nun durch eine konforme Abscheidung von SiO₂ und anisotropes Rückätzen dieser Schicht Flankenisolationsschichten 19 (sogenannte side wall oxide spacer) erzeugt. Dabei werden durch das anisotrope Ätzen die Source/Drain-Bereiche des MOS-Transistors frei geätzt. Die Flankenisolationsschichten verhindern bei der nachfolgenden Tantaldisilizidabscheidung (27, 28) die Silizidabscheidung an den Seitenwänden der Widerstände 14 sowie der Gates 24 und gewährleisten so die Isolation von Source/Drain-Gebieten (unter den Bereichen 28) zur Gateelektrode 24. Die selektive Abscheidung von Tantaldisilizid (17, 27, 28) erfolgt auf den nicht mit Oxid (5, 19, 2) bedeckten polykristallinen Siliziumoberflächen zur Bildung der Gates und der Anschlüsse. Alle weiteren Prozeßschritte erfolgen wie bei Figur 3 beschrieben.

## Patentansprüche

1. Integrierte MOS-Transistoren oder MOS-Transistoren und Bipolar-Transistoren und als Dünnschichtstege (14) auf den die aktiven Transistorbereiche trennenden Feldoxidbereichen (2) angeordnete Lastwiderstände enthaltende Schaltung mit Gate-Elektroden (24, 27) oder mit Gateelektroden und Emitter- bzw. Basisanschlüssen aus einer Doppelschicht aus polykristallinem Silizium (4, 24) und einem hochschmelzenden Metallsilizid (27), **dadurch gekennzeichnet,** daß die Lastwiderstände (14) in der gleichen Ebene wie die Gate-Elektroden (4, 24) angeordnet sind und aus dotierten, polykristallinen Siliziumschichtstrukturen (4, 14) und ihre Anschlüsse (17) aus einem hochschmelzenden Metallsilizid (7) bestehen.

2. Integrierte Schaltung nach Anspruch 1, **dadurch gekennzeichnet,** daß die aus polykristallinem Silizium bestehenden Lastwiderstände (14) Flankenisolationsschichten (19) (sog. spacer) aufweisen.

3. Integrierte Schaltung nach Anspruch 1 oder 2, **dadurch gekennzeichnet,** daß das Metallsilizid (7, 17, 27) aus Tantaldisilizid (TaSi₂) besteht.

4. Verfahren zum Herstellen einer integrierten Schaltung nach einem der Ansprüche 1 bis 3, **dadurch gekennzeichnet,** daß die aus polykristallinem Silizium (4) bestehenden Lastwiderstände (14) gleichzeitig mit der Abscheidung der die Gateelektroden (24) oder die Gateelektroden (24) und Emitter- und/oder Basisanschlußbereiche bildenden polykristallinen Siliziumschichten (4) als Dünnschichtstege (14) auf den die aktiven Transistorbereiche trennenden Feldoxidbereichen (2) hergestellt und unter Verwendung einer Oxidmaske (5) strukturiert werden und daß die Strukturierung ihrer Anschlüsse (17) gleichzeitig mit der Strukturierung der Gate-Elektroden (24, 27) der MOS-Transistoren oder der Gate-Elektroden (24, 27) der MOS-Transistoren und der Emitter- und/oder Basisanschlüsse der Bipolartransistoren vorgenommen wird.

5. Verfahren nach Anspruch 4, **dadurch gekennzeichnet,** daß die Dotierung der die Lastwiderstände (14) bildenden polykristallinen Siliziumschich (4) während der Abscheidung der Schicht (4) oder im Anschluß daran durch Ionenimplantation und/durch Diffusion durchgeführt wird.

6. Verfahren nach Anspruch 4 oder 5, **dadurch gekennzeichnet,** daß die aus polykristallinem Silizium (4) bestehenden Lastwiderstände (14) und die Gate-Elektroden (24) durch Abscheiden einer konformen Oxidschicht und anisotropes Rückätzen dieser Schicht mit Flankenisolationsschichten (19) versehen werden und daß die Anschlüsse (17) für die Lastwiderstände (14), die Gate-Elektroden (24, 27) und die Source/Drain-Anschlüsse (28) oder die Anschlüsse (17) für die Lastwiderstände (14), die Gate-Elektroden (24, 27) und die Source/Drain-Anschlüsse (28) und die Emitter- und/oder Basisanschlüsse der Schaltung durch selektive Silizidabscheidung auf den nicht mit Oxid (2, 5, 19) bedeckten einkristallinen und polykristallinen Siliziumoberflächen (1, 14, 24) gebildet werden.

## Claims

1. Integrated circuit which contains MOS transistors, or MOS transistors and bipolar transistors, and load resistors disposed as thin-layer ridges (14) on the field-oxide regions (2) isolating the active transistor regions, and which has gate electrodes (24, 27) or which has gate electrodes and emitter or base connections comprising a double layer of polycrystalline silicon (4, 24) and a refractory metal silicide (27), characterised in that the load resistors (14) are disposed in the same plane as the gate electrodes (4, 24) and comprise doped polycrystalline silicon layer patterns (4, 14) and their connections (17) comprise a refractory metal silicide (7).

2. Integrated circuit according to Claim 1, characterised in that the load resistors (14) comprising polycrystalline silicon have edge insulating layers (19) (so-called spacers).

3. Integrated circuit according to Claim 1 or 2, characterised in that the metal silicide (7, 17, 27) comprises tantalum disilicide (TaSi₂).

4. Process for producing an integrated circuit according to one of Claims 1 to 3, characterised in that the load resistors (14) comprising polycrystalline silicon (4) are produced at the same time as the deposition of the polycrystalline silicon layers (4) forming the gate electrodes (24), or the gate electrodes (24) and emitter- and/or base-connection regions, as thin-layer ridges (14) on the field-oxide regions (2) isolating the active transistor regions and are patterned using an oxide mask (5), and in that the patterning of their connections is carried out at the same time as the patterning of the gate electrodes (24, 27) of the MOS transistors, or the gate electrodes (24, 27) of the MOS transistors and the emitter and/or base connections of the bipolar transistors.

5. Process according to Claim 4, characterised in that the doping of the polycrystalline silicon layer (4) forming the load resistors (14) is carried out during the deposition of the layer (4) or subsequent thereto by ion implantation and/or by diffusion.

6. Process according to Claim 4 or 5, characterised in that the load resistors (14) comprising polycrystalline silicon (4) and the gate electrodes (24) are provided with edge insulating layers (19) by depositing conformal oxide layer and anisotropically back-etching said layer, and in that the connections (17) for the load resistors (14), the gate electrodes (24, 27) and the source/drain connections (28), or the connections (17) for the load resistors (14), the gate electrodes (24, 27) and the source/drain connections (28), and the emitter and/or base connections of the circuit are formed by selective silicide deposition on the monocrystalline and polycrystalline silicon surfaces (1, 14, 24) not covered with oxide (2, 5, 19).

## Revendications

1. Circuit intégré comportant des transistors MOS ou des transistors MOS et des transistors bipolaires et des résistances de charge disposées, en barrettes à couche mince (14), sur la zone d'oxyde de champ (2) séparant les zones actives des transistors et comportant des électrodes de grille (24,27) ou des électrodes de grille et des bornes d'émetteur et de base d'une couche double de silicium polycristallin (4,24) et d'un siliciure métallique (27) à haut point de fusion, caractérisé en ce que les résistances de charge (14) sont disposées sur le même plan que les électrodes de grille (4,24) et sont constituées de structures de couche de silicium (4,14) polycristallines dopées et leurs bornes (17) sont constituées de siliciure métallique (7) à haut point de fusion.

2. Circuit intégré selon la revendication 1, caractérisé en ce que les résistances de charge (14) constituées de silicium polycristallin comportent des couches isolantes de flancs (19) (connues sous le nom de spacer).

3. Circuit intégré selon la revendication 1 ou 2, caractérisé en ce que le siliciure métallique (7,17,27) est constitué de disiliciure de tantale (TaSi₂).

4. Procédé pour fabriquer un circuit intégré selon l'une des revendications 1 à 3, caractérisé en ce que les résistances de charge (14) constituées de silicium (4) polycristallin, sont fabriquées, sous la forme de barrettes à couches minces (14), sur les zones d'oxyde de champ (2) qui séparent les zones actives des transistors, en même temps que le dépôt des couches de silicium (4) polycristallines qui forment les électrodes de grille (24) ou les électrodes de grille (24) et les zones de connexion d'émetteur et/ou de base, et sont structurées en utilisant un masque d'oxyde, et en ce que la structuration de leurs bornes (17) est opérée en même temps que la structuration des électrodes de grille (24, 27) des transistors MOS ou des électrodes de grille (24, 27) des transistors MOS et des bornes d'émetteur et/ou de base des transistors bipolaires.

5. Procédé suivant la revendication 4, caractérisé en ce que le dopage de la couche polycristalline de silicium (4) formant les résistances de charge (14), est effectué pendant le dépôt de la couche (4) ou après celui-ci par implantation d'ions et/ou par diffusion.

6. Procédé selon la revendication 4 ou 5, caractérisé en ce que les résistances de charge (14) constituées de silicium (4) polycristallin et les électrodes de grille (24) sont munies, par dépôt d'une couche d'oxyde conforme et par gravure anisotrope en retrait de cette couche, avec de couches isolantes de flanc (19) et en ce que les bornes (17) pour les résistances de charge (14), pour les électrodes de grille (24, 27) et pour les bornes (28) de source/drain ou les bornes (17) pour les résistances de charge (14), pour les électrodes de grille (24, 27) et pour les bornes (28) de source/drain et les bornes d'émetteur et/ou de base du circuit, sont formées par un dépôt sélectif de siliciure sur les surfaces de silicium (1,14,24) monocristallines et polycristallines qui ne sont pas recouvertes d'oxyde (2, 5, 19).
